Europäisches Patentamt

European Patent Office

Office européen des brevets

(19)

(11) Numéro de publication: **0 189 692 B1**

(12) ## FASCICULE DE BREVET EUROPEEN

(45) Date de publication de fascicule du brevet:
27.02.91

(51) Int. Cl.⁵: **H03K 3/537**

(21) Numéro de dépôt: **85402487.4**

(22) Date de dépôt: **13.12.85**

(54) Générateur de fortes impulsions de courant synchrones sur sorties parallèles.

(30) Priorité: **26.12.84 FR 8419807**

(43) Date de publication de la demande:
**06.08.86 Bulletin 86/32**

(45) Mention de la délivrance du brevet:
**27.02.91 Bulletin 91/09**

(84) Etats contractants désignés:
**CH DE LI**

(56) Documents cités:
**GB-A- 1 147 906**

**THE REVIEW OF SCIENTIFIC INSTRUMENTS,**
vol. 36, no. 1, janvier 1965, pages 13-15, New
York, US; A. LIETTI: "30-40 Megawatts rf line
pulse generator"

**INSTRUMENTS AND EXPERIMENTAL TECHNI-
QUES,** vol. 26, no. 2, partie 1, mars-avril 1983,
pages 359-362, Plenum Publishing Corp.,
New York, US; A.K. TKACHENKO et al.:
"Low-inductance current pulse generator"

(73) Titulaire: **COMMISSARIAT A L'ENERGIE ATO-
MIQUE Etablissement de Caractère Scientifique Technique et Industriel
31/33, rue de la Fédération
F-75015 Paris(FR)**

(72) Inventeur: **Climent, Jean-Pierre
7, rue Max Jacob
F-91100 Saint Germain Des Corbeilles(FR)**
Inventeur: **Tronel, Jean-Claude
5, rue Gascogne
F-91220 Bretigny-Sur-Orge(FR)**
Inventeur: **Yastroubinski, Adolphe
Rue Frère Rouyère 20 Domaine Fougères
F-33600 Pessac(FR)**

(74) Mandataire: **Mongrédien, André et al
c/o BREVATOME 25, rue de Ponthieu
F-75008 Paris(FR)**

## Description

La présente invention a pour objet un générateur de fortes impulsions de courant synchrones sur sorties parallèles. Par fortes impulsions de courant, on entend une impulsion dont l'intensité est de l'ordre d'une dizaine de kiloampères et dont la largeur à mi-hauteur est de l'ordre de quelques microsecondes. Une telle impulsion de courant délivrée sur une ligne électrique permet de simuler l'injection d'une impulsion de courant due à une forte impulsion électromagnétique. Le générateur de l'invention délivrant des impulsions de courant synchrones sur plusieurs sorties parallèles permet notamment de tester les dispositifs électriques reliés à un réseau électrique polyphasé, par exemple le réseau triphasé basse tension.

Dans le cas d'un réseau basse tension, l'impulsion électromagnétique injectant une impulsion de courant parasite en mode commun dans ce réseau peut être représentée par un générateur équivalent de Norton ayant les caractéristiques suivantes :
- courant de court circuit : I = 30 KA,
- largeur à mi-hauteur : $t_h$ = 2 $\mu$s.

On connaît un générateur de courant à sortie unique ayant ces caractéristiques. Ce générateur connu présente plusieurs inconvénients. Il doit notamment être équipé d'un blindage de protection pour absorber le rayonnement dû à la source de très haute tension qui délivre 300 KV. Ce blindage confère au générateur un poids et une dimension importants qui limitent son transport. Les appareils électriques que l'on désire tester doivent donc être déplacés de leur lieu d'implantation vers le laboratoire où se trouve le générateur. De plus, ce générateur connu est complexe. Ce générateur est donc coûteux.

Des études ont été faites sur l'incidence de la forme de l'impulsion de courant sur le comportement d'un appareil électrique recevant cette impulsion. Ces études ont été faites notamment dans le cas où l'appareil à tester est un système de protection disposé entre un réseau électrique basse tension et un équipement électrique à protéger.

Un tel système de protection est décrit dans la demande de brevet français n° 84 06062 déposée le 17 avril 1984. Il comporte essentiellement un écrêteur ayant pour fonction de dériver la majeure partie de l'énergie de l'impulsion de la ligne du réseau et un filtre passe-bas dont le rôle est d'atténuer l'intensité de la perturbation dans la gamme des fréquences élevées.

Le comportement d'un tel système de protection face à une impulsion de courant produite par une impulsion électromagnétique intense est essentiellement fonction de deux paramètres de cette impulsion qui sont d'une part sa pente, en tension et en courant, et d'autre part sa largeur à mi-hauteur.

La pente de cette impulsion conditionne la réponse dynamique de l'écrêteur. La pente en tension détermine la tension d'amorçage dynamique de l'écrêteur et la pente en intensité détermine la tension développée aux bornes du circuit. Quant à la largeur à mi-hauteur de l'impulsion de courant injectée, elle agit par son spectre de fréquence sur la réponse du filtre basse-bas.

On connaît un générateur d'impulsions de courant délivrant une impulsion de courant dont la pente et la largeur à mi-hauteur sont représentatives d'une forte impulsion électromagnétique.

Ce générateur est plus simple que le générateur précédent puisque tous les paramètres de l'impulsion de courant ne sont pas reproduits. Il nécessite toutefois une source de tension de 100 KV pour la production de l'impulsion de courant. Il requiert donc, comme le générateur précédent, un blindage de protection contre les rayonnements de cette source de tension.

Le périodique professionel "Instruments and Experimental Techniques", Mars-Avril 1983, pages 359-362, décrit un générateur d'impulsions de courant monophasé qui comprend un étage haute tension, un étage générateur d'impulsions et un étage de déclenchement. L'étage générateur d'impulsions est muni d'un condensateur de stockage chargé par l'étage haute tension et déchargé par un éclateur relié en serie entre une borne du condensateur de stockage et une borne de sortie, l'étage de déclenchement appliquant un signal de déclenchement à une borne de commande de l'éclateur.

Par ailleurs, les deux générateurs connus qui viennent d'être évoqués présentent également un inconvénient important pour le test en mode commun sur les réseaux électriques polyphasés. En effet, ces générateurs sont à sortie unique. Pour l'utilisation sur un réseau polyphasé, ils doivent donc être équipés d'un système de découplage capacitif afin que l'impulsion produite soit répartie sur chaque phase du réseau attaqué.

L'invention a pour objectif de remédier aux inconvénients des générateurs connus. Elle a notamment pour but de diminuer les dimensions, le poids et le coût d'un générateur de fortes impulsions de courant. Elle a pour objet un générateur d'impulsions de courant dans lequel la source de tension est plus faible que dans les générateurs connus, ce qui permet de supprimer le blindage de protection. De plus, le générateur objet de l'invention comporte une pluralité de modules aptes à délivrer chacun une même impulsion de courant. Ces modules sont commandés simultanément, ce qui permet d'attaquer un réseau polyphasé avec un ensemble d'impulsions de courant synchrones.

De manière précise, l'invention a pour objet un générateur de fortes impulsions de courant synchrone sur sorties parallèles comprenant les caractéristiques énoncées dans la revendication 1.

De manière préférée, le moyen de commande de déclenchement comprend un déclencheur et un circuit de commande, ledit déclencheur comprenant deux éclateurs en cascade alimentés par l'étage haute tension et commandés par ledit circuit de commande.

Selon une autre mode de réalisation préféré, dans le cas où le générateur délivre les impulsions de courant sur un réseau alternatif, monophasé ou polyphasé, le circuit de commande active le déclencheur à un instant déterminé fonction de la phase d'un signal dudit réseau.

Les caractéristiques et avantages de l'invention ressortiront mieux de la description qui va suivre, donnée à titre illustratif mais non limitatif, en référence aux dessins annexés, sur lesquels :

- la figure 1 représente schématiquement le générateur d'impulsions de courant de l'invention, ledit générateur comprenant trois modules pour l'injection de trois impulsions de courant synchrones dans un réseau triphasé,
- la figure 2 représente un mode particulier de réalisation de l'un des modules du générateur de la figure 1, et
- les figures 3a et 3b représentent respectivement l'allure d'une impulsion de courant délivrée par un module du générateur de l'invention et l'allure du signal typique délivré par un système de protection recevant ladite impulsion de courant.

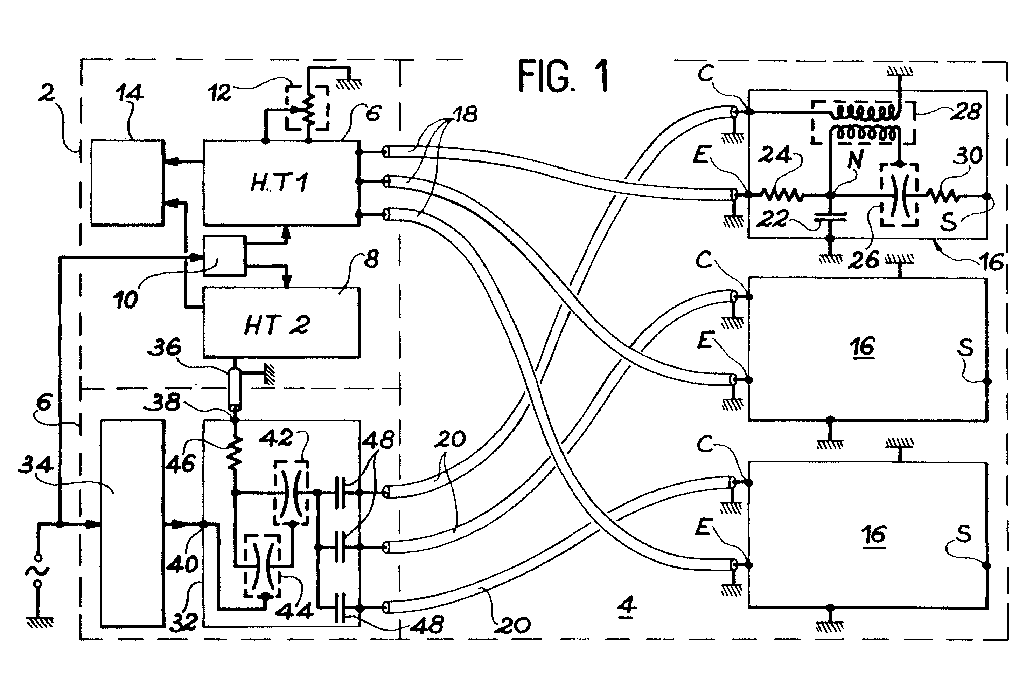

On a représenté schématiquement sur la figure 1 un mode de réalisation du générateur d'impulsions de courant de l'invention. Ce générateur comprend trois éléments : un étage haute tension 2, un ensemble de modules 4 alimentés chacun par l'étage haute tension 2 et délivrant une impulsion de courant, et un moyen de commande 6 pour commander l'émission synchrone des impulsions de courant de chaque module.

L'étage haute tension 2 comprend essentiellement une première source de haute tension continue 6 et une deuxième source de haute tension continue 8. Ces deux sources de haute tension sont alimentées par un boîtier d'alimentation 10 relié, par exemple, au réseau alternatif basse tension.

La première source 6 délivre une pluralité de signaux de tension identiques destinés à chaque module de l'ensemble 4. L'intensité de ces signaux de tension peut être réglée par un moyen 12 par un opérateur. Le niveau de tension choisi définit l'intensité en courant de l'impulsion délivrée par chaque module. Les tensions délivrées par cette première source de haute tension 6 sont par exemple comprises entre 0 et 15 KV.

Le signal de tension délivré par la deuxième source de haute tension 8 alimente le moyen de commande 6. Cette tension est par exemple comprise entre 0 et 7,5 KV. Elle peut être ajustée par un moyen interne à la source 8. Les niveaux de tension délivrés par la première source 6 et la deuxième source 8 sont affichés sur un moyen de visualisation 14.

Dans le mode de réalisation représenté sur la figure 1, l'ensemble 4 comporte trois modules 16 identiques. Il est bien entendu que ce nombre est uniquement illustratif et que le générateur de l'invention peut comporter un nombre quelconque de modules. Le cas particulier d'un générateur comprenant trois modules est intéressant en pratique car il permet le test des équipements électriques reliés au réseau triphasé.

Chaque module 16 comporte une borne d'entrée E, une borne de sortie S et une borne de commande C. La borne d'entrée est reliée à l'une des sorties de la première source de haute tension 6 par une liaison coaxiale 18. De même, la borne de commande de chaque module 16 est reliée au moyen de commande 6 par une liaison coaxiale 20.

Chaque module 16 délivre sur sa borne de sortie S une forte impulsion de courant sur réception d'un signal de commande émis par le moyen de commande 6. Les impulsions de courant délivrées par les modules sont synchrones.

Chaque module 16 comprend trois éléments. Un moyen de stockage d'énergie pour stocker l'énergie reçue de la source de haute tension 6, un interrupteur disposé entre ce moyen de stockage et la borne de sortie S, et un moyen de commande de l'ouverture de cet interrupteur.

Dans le dessin schématique de la figure 1, le moyen de stockage est constitué par un condensateur 22 auquel est associée une résistance de charge 24. Le condensateur 22 est relié d'une part à un noeud électrique N et d'autre part à la masse ; la résistance de charge 24 est reliée à la borne d'entrée E et au noeud électrique N.

L'interrupteur est un éclateur 26 disposé entre le noeud électrique N et la borne de sortie S. Le signal de commande de l'état de l'interrupteur émis par le moyen de commande 6 sur la liaison coaxiale 20 est transmis à l'interrupteur par l'intermédiaire d'un transformateur 28. Les bornes du circuit primaire de ce transformateur sont reliées respectivement à la borne de commande C et à la masse ; les bornes du circuit secondaire sont reliées au noeud électrique N et à l'entrée de commande de l'interrupteur.

Chaque module peut comporter en outre une résistance d'adaptation d'impédance 30 entre l'interrupteur et la borne de sortie S.

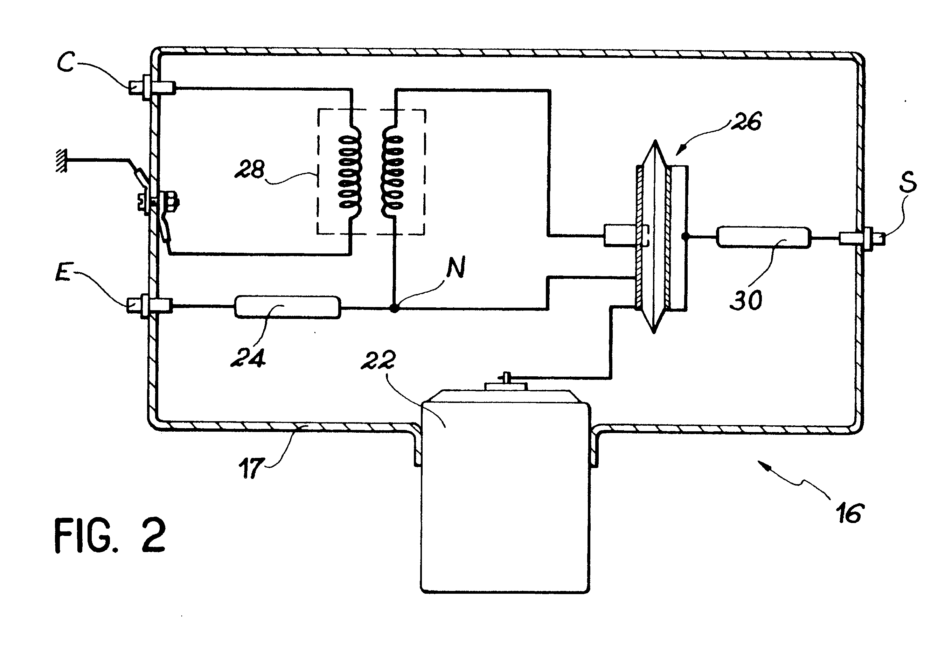

On décrira en référence à la figure 2 un mode particulier de réalisation d'un module 16.

On va maintenant décrire le moyen de commande 6 du générateur de la figure 1. Ce moyen de commande comprend un déclencheur 32 et un circuit de commande du déclencheur 34. Le déclencheur 32 est alimenté par la deuxième source de haute tension 8 par l'intermédiaire d'une liaison coaxiale 36. Il est muni de trois sorties pour délivrer un signal de commande identique sur la borne de commande C de chaque module 16 par les liaisons coaxiales 20. Il comporte enfin une entrée de commande 40 pour recevoir un signal de commande de déclenchement du circuit de commande 34.

Dans l'exemple de réalisation représenté sur la figure 1, le déclencheur 32 comprend deux éclateurs 42, 44, une résistance de charge 46 et trois condensateurs d'isolement 48. Les deux éclateurs 42 et 44 sont en cascade. Leurs entrées sont reliées à l'entrée d'alimentation 38 par la résistance de charge 46. La sortie de l'éclateur 42 est reliée à l'une des bornes de chacun des condensateurs 48 dont l'autre borne est reliée à une liaison coaxiale 20. L'électrode de commande de l'éclateur 42 est reliée à la sortie de l'éclateur 44 dont l'électrode de commande est pilotée par le circuit de commande de déclenchement 34. A titre d'exemple, ces éclateurs 42 et 44 peuvent être respectivement du type GP91 et KN6B de Edgerton.

Le circuit de commande de déclenchement 34 définit l'instant de sortie des impulsions de courant des modules. Ce circuit 34 est particulièrement avantageux dans le cas où les impulsions de courant délivrées par le générateur de l'invention sont injectées dans un réseau alternatif. Dans ce cas, si le circuit 34 reçoit ledit signal alternatif, ou l'une des phases de ce signal, comme on l'a représenté sur la figure 1, ledit circuit peut commander l'instant d'émission des impulsions de courant du générateur en fonction de la phase dudit signal alternatif.

Ceci est intéressant car la réponse d'un appareil électrique, ou d'un système de protection, relié au réseau électrique alternatif soumis à une impulsion de courant injectée par une impulsion électromagnétique peut varier en fonction de l'instant d'apparition de cette impulsion de courant par rapport à la phase du signal du réseau. Le circuit de commande de déclenchement 34 permet de définir avec précision, et de manière reproductible, l'instant d'émission des impulsions de courant dans le réseau. Il rend ainsi possible un test très complet d'un appareil électrique soumis à une forte impulsion de courant.

On va maintenant décrire, en référence à la figure 2, un mode de réalisation particulier d'un module 16. Sur cette figure, les références identiques à celles de la figure 1 désignent les mêmes éléments.

Les éléments du module sont disposés dans une enceinte métallique 17 reliée à la masse. La borne de commande C, la borne d'entrée E et la borne de sortie S sont réalisées par exemple par des fiches BNC traversant cette enceinte. Le condensateur de stockage d'énergie 22 est par exemple du type MAXWELL. Sa capacité est de 3µF. La résistance de charge 24 associée à ce condensateur a une valeur de quelques kiloohms.

L'éclateur 26 est par exemple de type TH9076 de Thomson. Le transformateur 28 est un transformateur d'isolement classique.

La résistance 30 constitue une adaptation d'impédance. Elle permet d'amener l'impédance constituée par l'appareil à tester et cette résistance 30 à une valeur désirée en fonction du niveau de la haute tension reçue par la borne d'entrée E du module 16. Par exemple, si l'on désire que l'impulsion de courant délivrée sur la borne de sortie S ait une intensité de 10 KA alors que la tension reçue sur la borne d'entrée E est de 10 KV, la résistance 30 devra être telle que l'impédance vue de la sortie de l'éclateur 26 soit de 1 ohm.

Si l'appareil à tester est un système de protection comportant un écrêteur et un filtre comme indiqué plus haut, son impédance est de l'ordre de quelques dixièmes d'ohm. La résistance 30 a alors également une valeur de quelques dixièmes d'ohm.

La résistance 30 d'adaptation d'impédance a été représentée sur la figure 2 à l'intérieur de l'enceinte 17. Elle pourrait également être disposée dans une enceinte isolée reliée à la borne de sortie S de l'enceinte 17. Cette dernière solution est préférable lorsque le générateur est utilisé pour tester le comportement d'appareils électriques différents ne nécessitant pas une même résistance d'adaptation d'impédance.

Les caractéristiques électriques générales d'un module sont donc les suivantes :
résistance : quelques dixièmes d'ohm,
inductance : quelques dixièmes de microhenry
capacité : quelques microfarads

Le demandeur a réalisé un générateur d'impulsions de courant comportant trois modules conformes à celui représenté sur la figure 2. Les caractéristiques de ce générateur sont les suivantes :
tension de charge des modules : 10 KV
résistance (résistance 30 + résistance d'entrée de l'appareil à tester) : 1 ohm,
capacité : 3 µF,
inductance : 0,5 µH.

Ce générateur délivre pour chaque module une impulsion de courant d'intensité 10 KA ayant une largeur à mi-hauteur de 2µs. Cette impulsion réalise une bonne simulation d'une impulsion injectée par une forte impulsion électromagnétique. Il faut noter en effet que si tous les paramètres d'une impulsion de courant produite par une impulsion électromagnétique ne sont pas satisfaits (le niveau de tension est par exemple de 10 KV au lieu de 300 KV), les paramètres caractéristiques de l'impulsion, qui déterminent le comportement de l'appareil à tester, sont pour leur part reproduits par le générateur de l'invention.

Le demandeur a utilisé ce générateur d'impulsions de courant pour tester un système de protection constitué d'un écrêteur suivi d'un filtre passe-bas. L'écrêteur, de type parafoudre, est constitué d'un éclateur et d'une varistance. Le filtre passe-bas est un filtre LC qui peut être de type $\pi$ ou de préférence de type L. Une inductance complémentaire peut être disposée entre l'écrêteur et le filtre passe-bas.

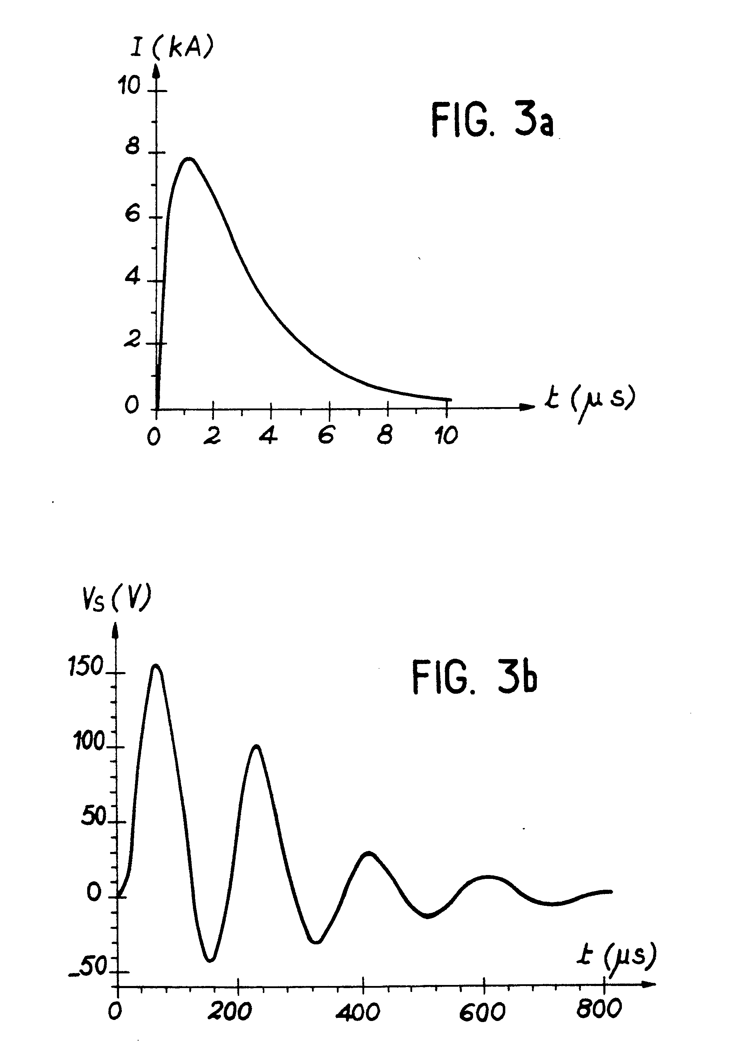

On a représenté sur la figure 3a l'impulsion de courant délivrée par chaque module du générateur de l'invention et sur la figure 3b la tension de sortie du filtre du système de protection. L'impulsion de courant est produite par la décharge d'un condensateur de 3 $\mu$F sur une résistance de 1 ohm. La tension de charge du condensateur délivrée par la source de tension est de 10 KV. L'inductance parasite due à la ligne de liaison entre le générateur et le système de protection - cette liaison pouvant être très courte (quelques centimètres) grâce au faible encombrement du module -, ajoutée à l'inductance propre du générateur, limite l'intensité de l'impulsion de courant délivrée à 8 KV.

Le rôle de l'écrêteur du système de protection est de dériver le maximum de courant et/ou d'énergie vers la terre et d'amener le niveau de tension de l'impulsion à une valeur minimale. Le filtre passe-bas situé en aval de cet écrêteur permet également d'écouler une fraction du courant et/ou de l'énergie non dérivée à l'écrêtage, mais permet également d'atténuer le niveau de tension de l'impulsion après l'écrêtage notamment dans la partie haute fréquence du spectre de l'impulsion.

La figure 3b illustre le signal de tension typique délivré par le système de protection. Cette tension a une forme sinusoïdale amortie ayant une pseudo-période d'environ 220 $\mu$s. Les deux premiers pics ont respectivement pour intensité environ 150V et 100V.

**Revendications**

1. Générateur de fortes impulsions de courant synchrones sur N sorties parallèles, caractérisé en ce qu'il comprend :
   - un étage haute tension (2) à N sorties ;
   - un ensemble (4) de N modules identiques, délivrant de fortes impulsions de courant synchrones, chaque module (16) étant muni pour cela d'une borne d'entrée (E) reliée à l'une des sorties de l'étage haute tension, d'une borne de commande (C) et d'une borne de sortie (S), et comprenant une résistance de charge (24) et un éclateur (26) en série entre la borne d'entrée et la borne de sortie, un condensateur de stockage (22) ayant une borne reliée au point commun entre ladite résistance de charge et ledit éclateur, et un transformateur (28) relié à la borne de commande et commandant ledit éclateur ; et
   - un moyen de commande de déclenchement (6) à N sorties pour appliquer des signaux de commande de déclenchement aux transformateurs (28) des modules, chaque borne de commande (C) étant reliée à l'une des sorties de ces moyens.

2. Générateur selon la revendication 1, caractérisé en ce que le moyen de commande de déclenchement comprend un déclencheur (32) et un circuit de commande (34) dudit déclencheur, ledit déclencheur (32) comprenant deux éclateurs en cascade (42, 44) alimentés par l'étage haute tension (2) et commandés par ledit circuit de commande (34).

3. Générateur selon la revendication 2, pour délivrer des impulsions de courant sur un réseau alternatif, monophasé ou polyphasé, caractérisé en ce que le circuit de commande (34) commande le déclencheur (32) en fonction de la phase d'un signal dudit réseau.

4. Générateur selon l'une quelconque des revendications 1 à 3, caractérisé en ce que les liaisons entre l'étage haute tension (2) et les bornes d'entrée (E) des modules, d'une part, et les liaisons entre le moyen de commande de déclenchement (6) et les bornes de commande (C) des modules, d'autre part, sont des liaisons coaxiales (18, 20).

**Claims**

1. Generator of strong synchronous current pulses on N parallel outputs, characterized in that it comprises a high voltage stage (2) with outputs, a group (4) of N identical modules, supplying strong synchronous current pulses, each module (16) being provided for this purpose with an input terminal (E), connected to one of the outputs of the high voltage stage, a control terminal (C) and an output terminal (S) and having a load impedance (24) and a spark gap (26) in series between the input terminal and the output terminal, a storage capacitor (22) having a terminal connected to the common point between said load impedance and said spark gap, and a transformer (28) connected to the control terminal and controlling said spark gap and a triggering control means (6) with N outputs for applying triggering control signals to the transformers (28) of the modules, each control terminal (C) being connected to one of the outputs of said means.

2. Generator according to claim 1, characterized in that the triggering control means comprises a triggering device (32) and a control circuit (34) for said triggering device (32), which has two spark gaps (42,44) in cascade supplied by the high voltage stage (2) and controlled by said control circuit (34).

3. Generator according to claim 2, for supplying current pulses to a monophase or polyphase a.c. mains, characterized in that the control circuit (34) controls the triggering device (32) as a function of the phase of a signal of said mains.

4. Generator according to any one of the claims 1 to 3, characterized in that the connections between the high voltage stage (2) and the input terminals (E) of the modules on the one hand and the connection between the triggering control means (6) and the control terminals (C) of the modules on the other are coaxial connections (18,20).

**Ansprüche**

1. Generator für synchrone, starke Stromimpulse an N parallelen Ausgängen, dadurch gekennzeichnet, daß er umfaßt:
   - eine Hochspannungsebene (2) mit H Ausgängen;
   - eine Anordnung (4) von N identischen Modulen, die starke, synchrone Stromimpulse abgeben, wobei jedes Modul (16) dazu mit einer Eingangsklemme (E), die mit einem der Ausgänge der Hochspannungsebene verbunden ist, einer Steuerungsklemme (C) und einer Ausgangsklemme (S) versehen ist und einen Ladewiderstand (24) und einen Entlader (26) in Reihe zwischen der Eingangsklemme und der Ausgangsklemme, einen Speicherkondensator (22) mit einer an dem gemeinsamen Punkt zwischen dem Ladewiderstand und dem Entlader angeschlossenen Klemme und einen Transformator (28) umfaßt, der mit der Steuerungsklemme verbunden ist und den Entlader Steuert;
   - eine Auslösungssteuerungsvorrichtung (6) mit N Ausgängen zum Anlegen von Auslösungssteuerungssignalen an die Modultransformatoren (28), wobei jede Steuerungsklemme (C) mit einem der Ausgänge dieser Vorrichtung verbunden ist.

2. Generator nach Anspruch 1, dadurch gekennzeichnet, daß die Auslösesteuerungsvorrichtung einen Auslöser (32) und einen Steuerungsschaltkreis (34) für den Auslöser umfaßt, wobei der Auslöser zwei Entlader in Kaskade (42, 44) umfaßt, die von der Hochspannungsebene (2) versorgt werden und von dem Steuerungsschaltkreis (34) gesteuert werden.

3. Generator nach Anspruch 2 zum Erzeugen von Stromimpulsen auf einem einphasigen oder mehrphasigen Wechselstromnetz, dadurch gekennzeichnet, daß der Steuerungsschaltkreis (34) den Auslöser (32) in Abhängigkeit von der Phase eines Signals des Netzes steuert.

4. Generator nach einem der Ansprüche 1 bis 3, dadurch gekennzeichnet, daß die Verbindungen zwischen der Hochspannungsebene (2) und den Eingangsanschlüssen (E) der Module auf der einen Seite und die Verbindungen zwischen den Auslösungssteuerungsvorrichtungen (6) und den Steuerungsklemmen (C) der Module auf der anderen Seite koaxiale Verbindungen (18, 20) sind.

# FIG. 1

EP 0 189 692 B1

FIG. 2

FIG. 3a

FIG. 3b